# EUROPÄISCHE PATENTANMELDUNG

(11) **EP 0 823 493 A1**
(43) Veröffentlichungstag der Anmeldung: **11.02.1998**
(21) Anmeldenummer: 97111945.8
(22) Anmeldetag: 14.07.1997
(51) Int. Cl.: C23C 16/54, C23C 16/50, C23C 16/02, H01J 37/32, C23C 16/26

(54) **Vorrichtung zur plasmachemischen Abscheidung von polykristallinem Diamant**

(30) Priorität: 05.08.1996 DE 19631407
(71) Anmelder: Leybold Systems GmbH, D-63450 Hanau am Main (DE)
(72) Erfinder: Liehr, Michael, Dr., 36325 Feldatal (DE); Bräuer, Günter, Dr., 63549 Freigericht (DE); Klages, Claus-Peter, Dr., 38102 Braunschweig (DE)

(57) **Zusammenfassung**

Bei einer Vorrichtung zur plasmatechnischen Abscheidung von polykristallinem Diamant auf großflächigen plattenförmigen Substraten (3), mit einer Vakuumkammer (4), mit Schleusen zum Ein- und Ausschleusen der Substrate, mit einer in der Kammer (4) angeordneten Einrichtung zum Fördern der Substrate (3) durch mindestens eine, vorzugsweise aber zwei Behandlungsstationen und mit eine erste Gruppe bildenden, oberhalb der Substratebene vorgesehenen Heißdrahtquellen (5,5',...) und mit eine zweite Gruppe bildenden Mikrowellenplasmaquellen (8,8',...) und mit einer unterhalb der Substratebene angeordneten, mit Radiofrequenz gespeisten Elektrode (11) zur Erzeugung einer Vorspannung und mit in die Vakuumkammer (4) einmündenden Gaszuleitungsrohren (6,9) erstrecken sich die als Linienquellen ausgebildeten Heißdrahtanordnungen (5,5',...) quer zur Substrattransportrichtung (A) und bilden eine erste Beschichtungszone (Z¹), wobei mit Abstand und parallel zu den Heißdrahtquellen (5,5',...) die Mikrowellenplasmaquellen (8,8',...) in einer Reihe angeordnet sind und zusammen eine zweite Beschichtungszone (Z²) bilden.

## Beschreibung

Die Erfindung betrifft eine Vorrichtung zur plasmachemischen Abscheidung von polykristallinem Diamant auf großflächigen plattenförmigen Substraten, mit einer Vakuumkammer, mit Schleusen zum Ein- und Ausschleusen der Substrate, mit einer in der Kammer angeordneten Einrichtung zum Fördern der Substrate durch mindestens zwei Behandlungsstationen und mit oberhalb der Substratebene angeordneten Quellen zum Abscheiden der Schicht.

Es ist bereits seit langem bekannt, Diamanten auf Diamantsubstraten aufwachsen zu lassen (Vakuumbeschichtung 5, Anwendungen Teil II, Prof. Dr. G. Kienel, VDI-Verlag GmbH, Düsseldorf 1993). Darüber hinaus wurde die Bedeutung des atomaren Wasserstoffs während des Aufwachsprozesses gefunden. Weiterhin ist es auch bekannt, Diamantschichten durch Heißdraht-Verfahren (Hot Filament-Methoden) durch alle Arten von Plasma-CVD (Mikrowellen, RF, DC, Bogenentladungen, Plasmastrahl) und aus C₂H₂/O₂-Flammen abzuscheiden.

Das Verfahren zum Aufbringen von Diamantschichten mittels Heißdrahtquellen, insbesondere die notwendigen Parameter hierfür, wie Drücke und Prozeßgaszusammensetzungen, sind ebenfalls bekannt und ausführlich beschrieben (Properties and Growth of Diamond, Gordon Davies, Kings College, London UK, published by INSPEC, the Institution of Electrical Engineers, 1994). Weitere Angaben über den Stand der Technik und über einen für das Abscheiden von Diamantschichten geeigneten Mikrowellen-PECVD-Reaktor finden sich in "Current and Prospective Fields of Application for Diamond Thin Films", Michael Liehr, April 1995, Department of Physics, Heriot-Watt University, Edinburgh.

Weiterhin ist der grundsätzliche Aufbau von CVD-Quellen für die Abscheidung von Diamantschichten beschrieben (Diamond Chemical Vapor Deposition, Huimin Lin und David S. Dandy, Noys Publications, Park Ridge, New Jersey, USA).

Schließlich sind bereits Produktionsanlagen zum Beschichten von Fensterscheiben mit optisch wirksamen Schichten bekannt (EP 0 219 273), bei denen die Substrate nach dem Einschleusen in die Prozeßkammer von einem Rollen- oder Plattenförderer unter mehreren Beschichtungsquellen, vorzugsweise Sputterkathoden hindurch transportiert und anschließend aus der Prozeßkammer wieder ausgeschleust werden.

Der vorliegenden Erfindung liegt die Aufgabe zugrunde, eine Vorrichtung des eingangs genannten Typs so auszubilden, daß mit ihr größere Substrate, beispielsweise Fensterscheiben, in einem kontinuierlichen Verfahren mit einer Diamantschicht versehen werden können, wobei diese Vorrichtung eine Behandlung der Substrate im großtechnischen Maßstab ermöglichen soll.

Diese Aufgabe wird erfindungsgemäß gelöst durch eine Einrichtung zum Fördern der Substrate durch die Behandlungsstationen und mit eine erste Gruppe bildenden, oberhalb der Substratkammer vorgesehenen Heißdrahtquellen und mit eine zweite Gruppe bildenden Mikrowellenplasmageneratoren und mit einer unterhalb der Substratebene angeordneten, mit Radiofrequenz gespeisten Elektrode zur Erzeugung eines Vorspannungspotentials und mit in die Vakuumkammer einmündenden Gaszuleitungsrohren, wobei die als Linienquellen ausgebildeten Heißdrahtanordnungen sich quer zur Substrattransportrichtung erstrecken und eine erste Beschichtungszone bilden und mit Abstand und parallel zu den Heißdrahtquellen die Mikroplasmaquellen in Reihe angeordnet sind und zusammen eine zweite Beschichtungszone bilden.

Weitere Einzelheiten und Merkmale sind in den Unteransprüchen näher beschrieben und gekennzeichnet.

Die Erfindung läßt die verschiedensten Ausführungsmöglichkeiten zu; eine davon ist in der anhängenden Zeichnung rein schematisch näher dargestellt, die eine Vorrichtung nach der Erfindung in perspektivischer Ansicht zeigt, wobei jedoch der besseren Übersichtlichkeit wegen die Seitenwände, das obere Wandteil und die Ein- und Ausschleusvorrichtungen nicht dargestellt sind.

Die Vorrichtung besteht im wesentlichen aus einem Plattenbandförderer 2 zum kontinuierlichen Transport von Flachglasscheiben 3 durch eine Vakuumkammer 4, einer ersten Gruppe von Beschichtungsquellen 5,5',... mit einer dieser in Substrattransportrichtung betrachtet vorgeschalteten Gasdusche 6 und mit dieser ersten Gruppe nachgeschalteten Gasabsaugstutzen 7, einer zweiten Gruppe von Beschichtungsquellen 8,8',... mit diesen vorgeschaltetem Gaseinlaß 9 und einem nachgeschalteten Absaugstutzen 10 und einer im Bereich de ersten Gruppe von Quellen vorgegebenen, an eine Hochfrequenzquelle angeschlossenen Elektrode 11 zur Erzeugung einer elektrischen Vorspannung im Bereich der ersten Gruppe von Beschichtungsquellen 5,5',... Die als Heißdrahtquellen 5,5',... ausgebildeten Quellen der ersten Gruppe sind so angeordnet, daß sich jeweils deren elektrisch geheizte Drähte 12,12',... quer zur Förderrichtung A über die einzelnen Quellen im Bereich dieser ersten Beschichtungszone Z¹ in zwei Reihen und zueinander versetzt an der Vakuumkammerwand gehalten sind. Zur Unterstützung des Heißdrahtprozesses während des Bekeimungsprozesses (oder der Nukleierung) ist unterhalb des Substrats 3 und der Förderplatte 2 eine Elektrode 11 elektrisch isoliert angeordnet, an der eine Vorspannung (Radiofrequenz) anliegt. Die Mikrowellenquellen 8,8',... der zweiten Beschichtungszone Z² sind ebenfalls über die Zone Z² so verteilt angeordnet, daß sich ihre Wirkzonen jeweils ergänzen und zusammen eine gleichmäßige Beschichtung der Substrate 3, die sich unter den Quellen 12,12',... in Pfeilrichtung A hindurch bewegen, ermöglichen.

Die gewünschten Diamantschichten werden aus der Gasphase im Beisein von atomaren Wasserstoff abgeschieden. Die kohlenstoffhaltigen Gasbestandteile (Precursoren), z.B. die Kohlenwasserstoffe, die die atomaren Bausteine der Diamantschichten liefern, bilden dabei nur einen geringen prozentualen Volumenanteil des über die Gasduschen 6 und 9 einströmenden Gasgemisches. Dabei können zusätzlich weitere Gase (z.B. sauerstoffhaltige Gase) zugemischt werden, um das Wachstumsverhalten und die Qualität der abzuscheidenden Diamantschichten zu kontrollieren. Gemeinsam ist allen PVD-Verfahren, daß die zu beschichtenden Oberflächen im allgemeinen vorbehandelt werden müssen. Darunter ist die sogenannte Nukleierungsphase zu verstehen, die dazu dient, Wachstumskeime auf der Oberfläche zu erzeugen, die in der nachfolgenden Wachstumsphase zu einzelnen Kristallen heranwachsen, die sich wiederum zu geschlossenen Schichten verbinden. Ohne diese Vorbehandlung ist das Abscheiden von geschlossenen Diamantschichten nahezu unmöglich.

Die Nukleierung erfolgt in der Zone Z¹ mit Hilfe des Heißdrahtverfahrens (Hot Filament-Method). Atomarer Wasserstoff und andere für das CVD-Verfahren in der Zone Z² zur Abscheidung von kristallinen Diamantschichten wichtige Radikale werden von den Heißdrähten 12,12',... durch thermische Dissoziation erzeugt. Die Drähte 12,12',... bestehen aus hochschmelzendem Metall, wie z.B. Wolfram oder Tantal, und werden auf Temperaturen von 1900°C bis 2500°C aufgeheizt. Das Substrat 3 befindet sich dabei in einem Abstand von wenigen Millimetern zu den Drähten 12,12',...

Bei dem in der Zone Z² wirkenden Mikrowellenplasmaverfahren werden die gasförmigen Reaktionspartner in einem mit hochfrequenten elektromagnetischen Wechselfeldern erzeugten Plasma aktiviert. Je nach Substratgröße und gewünschten Wachstumsraten sind bevorzugt 2,45 GHz oder 915 MHz Mikrowellensender 13,13',... im Leistungsbereich von 1 bis 75 kW (c/w) einsetzbar.

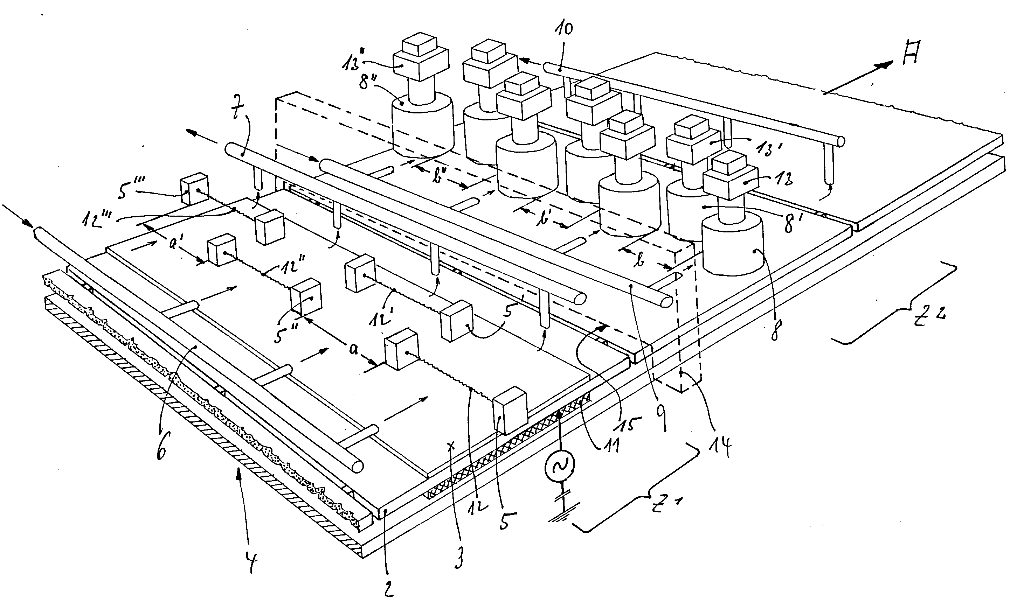

Wie die Zeichnung zeigt, sind die beiden Zonen Z¹, Z² gastechnisch voneinander getrennt: Das Prozeßgas für die Bekeimung strömt über die Gasdusche 6 in den Behandlungsbereich ein und wird anschließend über die Rohrleitung 7 aus der Zone Z¹ abgezogen. In gleicher Weise wird das Prozeßgas für das Mikrowellenplasma über die Gasdusche 9 in den Behandlungsbereich eingeführt und kontinuierlich über das Absaugrohr 10 aus der Zone Z² abgezogen. Zweckmäßigerweise ist eine Trennwand 14 zwischen den beiden Behandlungszonen Z¹ und Z² (in der Zeichnung strichliert angedeutet) vorgesehen, so daß eine Vermischung der beiden in ihrer Zusammensetzung verschiedenen Prozeßgase ausgeschlossen wird. Es ist klar, daß an beiden Enden der Vorrichtung Schleusen erforderlich sind, über die die Substrate 3,3',... eingeschleust bzw. wieder ausgeschleust werden. Nicht dargestellt sind in der Zeichnung auch Kühleinrichtungen, mit deren Hilfe eine Überhitzung der Substrate während des Beschichtungsvorgangs vermieden wird. Derartige Kühlvorrichtungen sind zweckmäßigerweise an den Innenwänden der Vakuumkammer 4 angeordnet, und zwar in Gestalt von einem von Kühlmittel durchströmten Rohrsystem.

### Bezugszeichenliste

- 2: Plattenbandförderer
- 3: Flachglasscheibe
- 4: Vakuumkammer
- 5,5',...: Heißdrahtquelle
- 6: Gaseinlaß, Gasdusche
- 7: Gasabsaugstutzen
- 8,8',...: Mikrowellenquelle
- 9: Gaseinlaß
- 10: Gasabsaugstutzen
- 11: HF-Elektrode
- 12,12',...: Heizdraht
- 13,13',...: Mikrowellensender
- 14: Trennwand
- 15: Spaltschleuse

## Patentansprüche

1. Vorrichtung zur plasmatechnischen Abscheidung von polykristallinem Diamant auf großflächigen plattenförmigen Substraten (3), mit einer Vakuumkammer (4), mit Schleusen zum Ein- und Ausschleusen der Substrate, mit einer in der Kammer (4) angeordneten Einrichtung zum Fördern der Substrate (3) durch mindestens eine, vorzugsweise aber zwei Behandlungsstationen und mit eine erste Gruppe bildenden, oberhalb der Substratebene vorgesehenen Heißdrahtquellen (5,5',...) und mit eine zweite Gruppe bildenden Mikrowellenplasmaquellen (8,8',...) und mit einer unterhalb der Substratebene angeordneten, mit Radiofrequenz gespeisten Elektrode (11) zur Erzeugung einer Vorspannung und mit in die Vakuumkammer (4) einmündenden Gaszuleitungsrohren (6,9), wobei die als Linienquellen ausgebildeten Heißdrahtanordnungen (5,5',...) sich quer zur Substrattransportrichtung (A) erstrecken und eine erste Beschichtungszone (Z¹) bilden und mit Abstand und parallel zu den Heißdrahtquellen (5,5',...) die Mikrowellenplasmaquellen (8,8',...) in einer Reihe angeordnet sind und zusammen eine zweite Beschichtungszone (Z²) bilden.

2. Vorrichtung nach Anspruch 1, **dadurch gekennzeichnet,** daß die beiden Gruppen von Quellen (5,5',... bzw. 8,8',...) in voneinander getrennten Abteilungen der Vakuumkammer (4) angeordnet sind, die durch eine Wand (14) mit Schleuse, beispielsweise eine Spaltschleuse (15) voneinander getrennt sind, wobei jeder Abteilung eine eigene Gasdusche (6 bzw. 9) und ein eigener Gasabsaugstutzen (7 bzw. 10) zugeordnet ist.

3. Vorrichtung nach den Ansprüchen 1 und 2, **dadurch gekennzeichnet**, daß die Substrate (3) auf einem Förderer, beispielsweise auf den Platten (2) eines Plattenförderers aufliegen, wobei die Platten (2) sich mit gleichbleibender Geschwindigkeit unter den Quellen (5,5',... bzw. 8,8',...) hindurch bewegen.

4. Vorrichtung nach den Ansprüchen 1 bis 3, **dadurch gekennzeichnet**, daß die Heißdrahtquellen (5,5',...) und die Mikrowellenquellen (8,8',...) in Förderrichtung (A) gesehen jeweils in zwei oder mehr hintereinander liegenden Reihen und mit Abstand zueinander angeordnet sind, wobei die Quellen der nächsten Reihen jeweils gegeneinander versetzt sind, so daß in Förderrichtung gesehen eine bestimmte Mindestüberlappung der Beschichtungsquellen erreicht wird.
